Europäisches Patentamt

European Patent Office

Office européen des brevets

(11) Publication number: **0 419 930 B1**

# EUROPEAN PATENT SPECIFICATION

(45) Date of publication of patent specification: **07.12.94**    (51) Int. Cl.5: **C23C 14/34**

(21) Application number: **90117459.9**

(22) Date of filing: **11.09.90**

(54) **Particulate contamination prevention scheme.**

(30) Priority: **26.09.89 US 412728**

(43) Date of publication of application:
**03.04.91 Bulletin 91/14**

(45) Publication of the grant of the patent:
**07.12.94 Bulletin 94/49**

(84) Designated Contracting States:
**BE DE ES FR GB IT NL**

(56) References cited:
**US-A- 4 728 389**
**US-A- 4 785 962**

**JOURNAL OF VACUUM SCIENCE AND TECHNOLOGY: PART A. vol. A7, no. 4, August 1989, NEW YORK US pages 2758 - 2765; SELWYN: 'Insitu laser diagnostic studies of plasma-generated particulate contamination. '**

(73) Proprietor: **APPLIED MATERIALS INC.**
**PO Box 58039**
**Santa Clara California 95052 (US)**

(72) Inventor: **Savas, Stephen E.**
**1220 Foothill Street**
**Redwood City California 94061 (US)**

(74) Representative: **Kahler, Kurt, Dipl.-Ing.**
**Patentanwälte Kahler, Käck, Fiener & Sturm**
**P.O. Box 12 49**
**D-87712 Mindelheim (DE)**

## Description

## Background of the Invention

This invention relates in general to particulate contamination in integrated circuit (IC) processing and relates more particularly to a plasma reactor design and process that greatly reduces the particulate contamination of wafers during etching of or deposit of thin films on a wafer within such a plasma reactor.

In the figures, the first digit of a reference numeral indicates the first figure in which is presented the element identified by that reference numeral.

Integrated circuit processing technology is continuously concerned with reducing the feature size of circuits to increase the amount of circuitry that can be packed onto an integrated circuit of a given size and to increase the speed of operation by reducing the distance that signals need to travel within such circuits. As feature size has decreased and as circuit complexity has increased, the effect of particulate contamination on process yields has become increasingly important. Particulates of diameter even several times smaller than the feature size of a component can cause failure of the IC if a particle was present at a critical location in the IC during a plasma process step.

Thus, the effect of particulates on yield is particularly critical for the submicron minimum feature size circuits available today because particulates as small as a fraction of a micron can make a circuit inoperable. The numbers of such particles has been found to increase rapidly with decreasing size. This problem is particularly acute for large area ICs such as microprocessors and $\geq$ 4 megabit memories because such ICs have an increased area over which a critical defect can occur.

The multilayer structure of typical ICs also increases the effect of particulates on yield. A particulate incorporated into one level of an IC can affect not only the circuitry on that level, but can also affect circuity on other levels. A defect in an embedded level of an IC can propagate through overlying layers, distorting the topography and thus disrupting operation of those circuit elements. For these reasons it is important to minimize the amount of particulates that come into contact with a wafer immediately before and during processing.

Particulate contamination is important in all phases and types of IC processing and is especially important in processes that utilize a plasma reactor. Plasma reactors can be used in a number of different phases of IC processing. These uses of plasma reactors include plasma etching, reactive ion etching and plasma enhanced chemical vapor deposition. Airborne particulates within a plasma reactor can settle onto a wafer, thereby potentially interfering with subsequently produced IC circuitry.

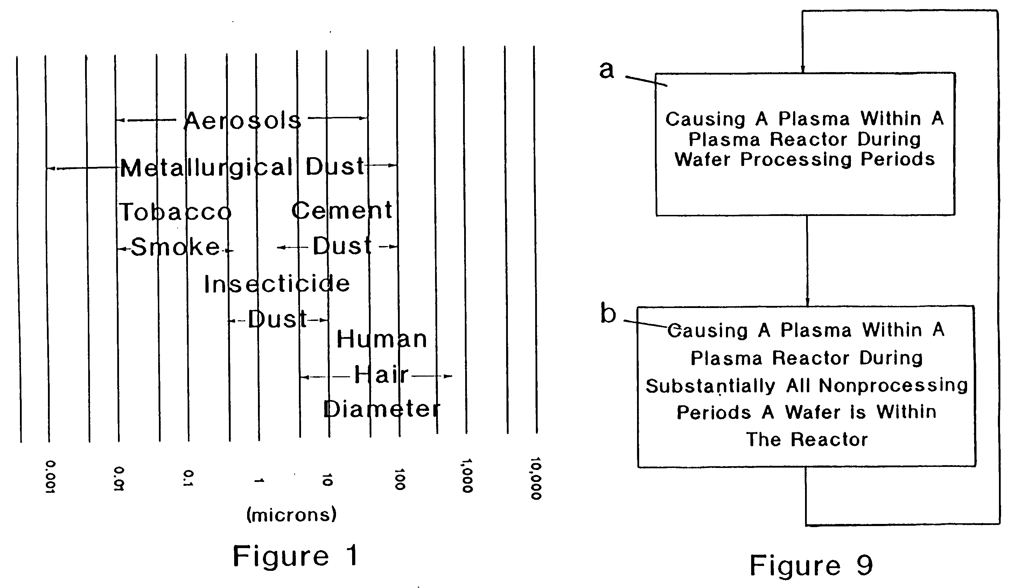

Figure 1 illustrates the relative size of some common airborne particulates (see, for example, chapter 7 of the text by Peter Van Zant entitled Microchip Fabrication, published by Semiconductor Services, San Jose, California, 1985). Expensive, intricate clean rooms and clean room procedures are utilized to significantly reduce the amount of airborne particulates to which a wafer is exposed during IC fabrication.

Unfortunately, clean rooms cannot prevent airborne particulates from getting into or being produced within a plasma reactor chamber. Even the most careful procedures cannot eliminate all particulates from the reactor chamber before processing begins. Reactant gases, even after filtering, and the wafers themselves can carry additional particulates into the processing chamber. Finally, the plasmas are usually such as to create or cause growth of submicroscopic particles due to their need to selectively etch a given film while not etching others.

In U.S. patent 4,728,389, entitled Particulate-free Epitaxial Process, issued to Roger E. Logan on March 1, 1988, an epitaxial process is presented that tries to minimize particulates within the processing chamber. Electrostatic attraction is substantially eliminated as a transport mechanism by the selective application of a low level of radiant or conductive thermal energy during cold portions of the epitaxial deposition process.

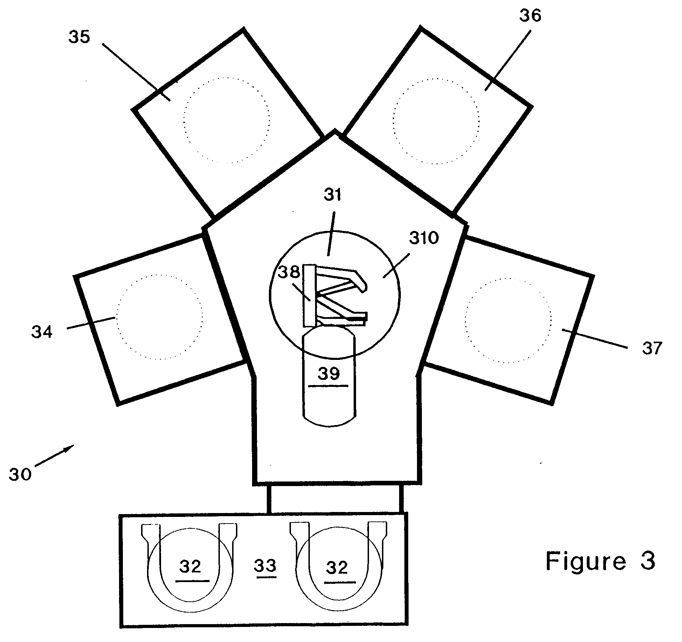

Figure 3 illustrates a wafer handling system 30 that allows a robot 31 to supply wafers to any of a plurality of IC processing chambers. This system enables wafers 32 to be exchanged between a wafer cassette elevator 33 and any of the chambers 34-37 without breaking vacuum in these chambers. Robot 31 includes an extensible arm 38 that can extend a wafer blade 38 radially into any of chambers 33-37. Arm 38 is mounted on a rotatable table 310 that enables extensible arm to be directed at any selected one of chambers 33-37. This enables the chambers to be carefully cleaned and purged before wafers are introduced for processing. Even if all particulates could have been purged from chambers 32-35 before processing, the mechanical steps of moving wafers among the chambers and from the wafer cassette elevator 31 to the chambers and back will produce some airborne particulates and the reactants will introduce some particulates.

## Summary of the Invention

Accordingly, it is the object of the present invention to provide a method and an apparatus for preventing some or all of the airborne particulates within the processing chambers from depositing on the wafers.

This object is achieved by a method of claim 1 and an apparatus of claim 9.

Inventive features of preferred embodiments of the invention are characterized in the dependent claims.

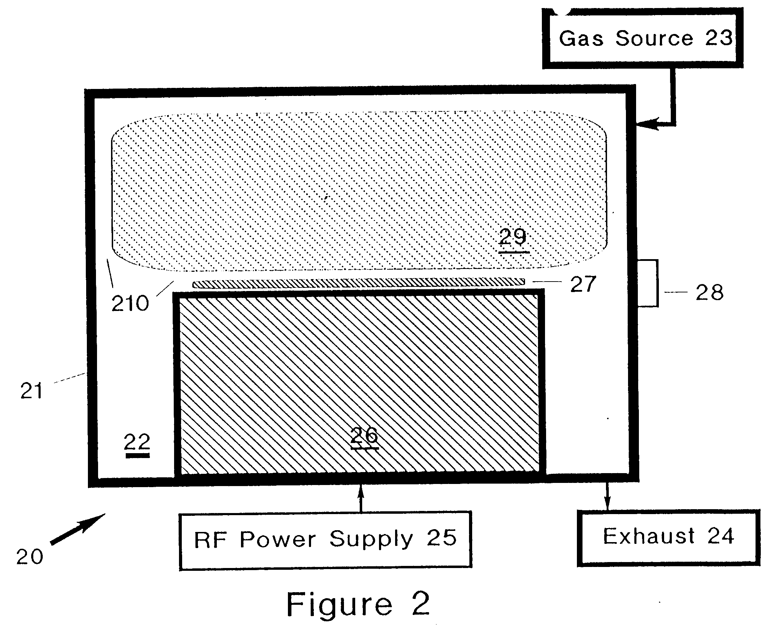

In accordance with the illustrated preferred embodiment, a plasma reactor design is presented that prevents most of the airborne particulates within a plasma reactor chamber from depositing on a wafer within the chamber. A typical existing plasma reactor is illustrated in Figure 2.

A plasma consists of two qualitatively different regions: the substantially neutral, conductive plasma body and a boundary layer called the plasma sheath. The plasma body consists of substantially equal densities of negative and positive charged particles as well as radicals and stable neutral particles. The plasma sheath is an electron deficient, poorly conductive region in which the electric field strength is large. The plasma sheath forms between the plasma body and any interface such as the walls of the plasma reactor chamber and the rf electrodes. Semiconductor process plasmas are usually produced by a radio frequency (rf) field that couples energy into free electrons within the chamber, imparting sufficient energy to many of these electrons such that ions can be produced through collisions of these electrons with gas molecules. Typically, the walls of the reactor chamber are metal (though often coated with thin insulating layers) so that they function as one of the rf electrodes. The powered rf electrode often also functions as a pedestal on which a wafer is placed for processing. This has the benefit of generating the strongest rf electric field and ion bombardment in the neighborhood of and on the wafer.

Because the electrons are on the order of thousands to hundreds of thousands of times lighter than the plasma ions, they experience an equally greater acceleration than the ions and therefore acquire from the rf field kinetic energies that are somewhat greater than those acquired by the ions. The effect of this is that the energy from the rf field is strongly coupled into electron kinetic energy and only very weakly coupled into ion kinetic energy. As a further result of this large mass difference between the electrons and the ions, collisions between the high energy (also referred to as high temperature) electrons and the ions does not transfer much of the electron energy to the ions. The effect of this is that the electrons acquire a temperature that is typically on the order of 1-5 ev and the other particles in the plasma remain substantially at the temperature of the walls of the plasma reactor chamber or up to a few hundred degrees Centigrade hotter.

Because the electrons are much more mobile than the ions, they initially strike the walls of the reactor chamber at a greater rate than do the ions. The effect of this is that the plasma body becomes slightly electron deficient while the boundary layer sheath becomes substantially electron deficient and thus positively charged at its interface with the electrodes. This net positive charge of the plasma body and boundary layer results in a plasma body electrical potential (usually called the "plasma potential") on the order of several times the electron mean kinetic energy divided by the electron charge. The potential in the bulk of the plasma is nearly constant while the largest part of the potential variation is across the sheath. In an rf plasma, this sheath potential is also dependent on various parameters including the area of the reactor chamber wall, the area of the powered electrode, the pressure in the reactor chamber and the rf power input (see, for example, J. Coburn and E. Kay, **J. Appl. Phys., 43**, p. 4965 (1972). The resulting time average sheath potential is approximately the sum of its value for a dc plasma, as described above, plus the amplitude of the rf component of the plasma potential.

To date, when a wafer was to be transferred into or out of the reactor chamber, the plasma has always been turned off so that wafer processing does not continue during this transfer interval. This is done because such processing while the wafer is being transferred would almost invariably degrade the circuit structure produced on the wafer. This is particularly true for submicron linewidth features since such small feature size can be produced only by extreme care in every step of the fabrication process. In particular, extensive steps are taken to make processing as uniform as possible over the entire area of the wafer. Such steps often involve making the plasmas substantially symmetric about an axis at which the wafer is centered for processing. Such axial symmetry would not continue if processing were continued as the wafer is transferred into or out of the plasma reactor chamber. Also, in some systems, the wafer is transferred into and out of the reactor chamber by a robot arm which would distort the process plasma if the power were not turned off during wafer transfer.

In accordance with the disclosed invention, it is recognized that, when the plasma is turned off, particulates within the reactor chamber begin to settle onto the wafer (also see the paper by G.S. Selwyn et al entitled *In situ laser diagnostic studies of plasma−generated particulate contamination*, **J. Vac. Sci. Technol. A 7(4), Jul/Aug 1989)**. This occurs immediately after processing, when a wafer is being transferred out of the reactor chamber or when a wafer is being transferred into the reactor chamber and immediately before processing. For the reasons discussed in the Background of the Invention, it is important to avoid letting these particulates settle onto the wafers. When a non-electronegative plasma (e.g., a plasma in which the concentration of negative ions does not greatly exceed that of electrons) is present in the reactor chamber, the high speed free electrons within the plasma quickly charge particulates negative within the plasma body. Because the plasma body is positively charged with respect to surfaces in ac contact with ground, the dc electric field across the plasma sheath between the plasma body and the powered electrode acts to hold these charged particulates away from both the powered electrode and the wafer located on the powered electrode. This dc electric field across the plasma sheath exists at any surface within the chamber, including the wafer surface. When the plasma is turned off, this electric field vanishes, thereby enabling the particulates to settle onto the wafer.

In accordance with the illustrated preferred embodiment, a plasma is maintained within the reactor chamber at all times that a wafer is within the chamber, including those times during which a wafer is being transferred into or out of the chamber. This may either be the active processing plasma or an auxiliary or supplemental plasma of moderate or low power produced either by the power supply for the process plasma or by an independent source. During the intervals of wafer transfer, the plasma density produced by this auxiliary plasma source is typically reduced from the level during the active process to a level just sufficient to prevent the particulates from settling onto the wafer. The gas supply during this period is substantially nonhalogenated in order to avoid both processing and an electronegative character of the plasma. Further, there may be an r.f. component introduced into the plasma potential in order to increase the time averaged sheath potential at the surface of the wafer (see, for example, A. Garscadden and K.G. Emeleus, **Proc. Phys. Soc.** 79, p. 535 (1962)). This level is typically significantly less than the level that occurs during wafer processing in the plasma reactor and avoids processing of the wafer during the periods of transfer into and out of the reactor chamber. As the density of the plasma decreases, both the charge on the particulates and the strength of the dc electric field at the wafer decrease. Therefore, the force on the particulates, which is the product of these two terms, decreases even faster than either of these terms. Thus, this lower density plasma for particulate protection must have a minimum density of electrons of order or greater than $10^8$ cm$^{-3}$.

During the wafer transfer periods, the plasma is preferably produced by an auxiliary plasma source located away from the wafer pedestal to further minimize processing of the wafer during these periods. Any plasma source can be used, including an auxiliary rf electrode, a hollow cathode or a microwave plasma cavity. The plasma reactor chamber should contain a wafer transfer valve with minimum area to reduce plasma flow into nonprocessing chambers during the wafer transfer.

**Description of the Figures**

Figure 1 illustrates the relative size of some common airborne particulates.

Figure 2 illustrates a typical plasma reactor.

Figure 3 illustrates a wafer handling system that allows a robot to supply wafers to a plurality of IC processing chambers.

Figure 4 illustrates a preferred embodiment of the invention utilizing an auxiliary rf plasma source.

Figure 5 illustrates in greater detail a simple choice of the auxiliary rf plasma source.

Figure 6 shows the timing of activation of the primary and secondary plasma sources.

Figure 7 shows the electrical equivalent circuit of a plasma reactor.

Figure 8 illustrates an alternate embodiment of the invention utilizing a microwave plasma source as the auxiliary plasma source.

Figure 9 outlines a method of keeping particulates away from a wafer in a plasma reactor.

**Description of the Preferred Embodiment**

Figure 9 outlines a method of keeping particulates away from a wafer in a plasma reactor. In accordance with this process, during periods in which a wafer is within the plasma reactor and during which no processing of the wafer is desired, a plasma of reduced intensity is produced to keep particulates away from the wafer while avoiding significant processing of the wafer.

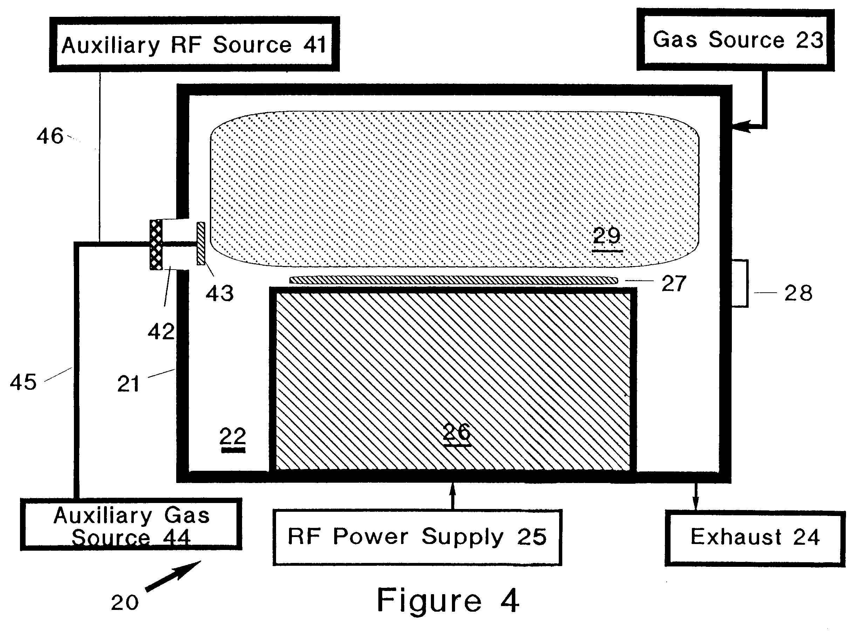

Figure 4 illustrates a conventional plasma reactor 20 to which has been added an auxiliary plasma source, such as auxiliary rf source 41, and an auxiliary gas source 44 to assist use of this reactor to practice the process of Figure 9. This reactor includes an aluminum wall 21 that encloses a plasma reactor chamber 22. Wall 21 is grounded and functions as one of the plasma electrodes. Gases are supplied to chamber 22 from a gas source 23 and are exhausted by an exhaust system 24 that typically actively pumps gases out of the reactor to maintain a low pressure suitable for a plasma process. An rf power supply 25 provides power to a second (powered) electrode 26 to generate a plasma within chamber 22. Although gas source 23 could provide gases to plasma chamber 22 during the wafer transfer periods, these gases are preferably provided by an auxiliary gas source 44. The gas supply for processing should be symmetrical with respect to the wafer to maintain process symmetry, but the gas supply for the auxiliary plasma should not be symmetrical. Indeed, it is advantageous during wafer transfer periods to direct these auxiliary gases across wafer 27 to sweep particulates away from the wafer surface toward exhaust 24. During the wafer transfer periods, auxiliary gas source 44 provides gasses to chamber 22 through a metallic feed that terminates in a set of holes in an electrode 43. RF power is provided to electrode 43 via a conductor 46 connecting auxiliary rf source 41 to gas feed 45 which is conductively coupled to electrode 43.

Powered electrode 26 also functions as a pedestal on which a wafer 27 is supported during processing within the reactor chamber. This has the advantage of locating the wafer at the location of strongest rf field, thereby enhancing the density of the plasma at the wafer. The wafer is transferred into and out of reactor chamber 22 through a port 28 such as the slit valve presented in U.S. patent 4,785,962 entitled Vacuum Chamber Slit Valve, issued to Massato Toshima on November 22, 1988. This slit valve has the advantages of effectively sealing chamber 22 during processing and of presenting a minimal area opening through which wafers are transferred into and out of chamber 22. This minimizes leakage of reactor gases through port 28 during wafer transfer into or out of chamber 22.

When power is applied to electrode 26, the resulting rf electric field in the chamber couples energy into free electrons which then ionize halogenated and other gases within the chamber, thereby producing a plasma body 29 surrounded by a plasma sheath 210. In general, the plasma sheath exists between the plasma body and all reactor chamber boundaries adjacent to the plasma body because of the higher mobility of the plasma electrons. When the plasma is first turned on, for a few microseconds, more electrons hit electrode 21 and wafer 27 than do ions such that the plasma becomes positively charged relative to both electrodes. This results in an electric field across the plasma sheath from the plasma body to both electrodes which is directed such as to accelerate positive ions outward from the plasma body and keep negative particles in. The dc component of the voltage of the plasma adjusts until a steady state is reached in which most electrons are repelled at the sheath such that zero dc electric current travels from the plasma's body 29 to ground. Actual values of the voltages can be determined from an equivalent circuit of this electrical structure discussed below.

It is the dc electric field across the plasma sheath near electrode 26 and wafer 27 that enables particulates to be repelled away from the wafer. Particulates in the plasma are continually struck by the positive ions and the negative electrons of the plasma. The particulates are macroscopic particles and therefore absorb most such incident electrons and ions. Because the plasma electrons are so much more mobile than the ions in the plasma, many many times more electrons initially strike an uncharged particulate than do ions. The result is that the particulates become negatively charged until they repel sufficient numbers of electrons that equal numbers of electrons and positive ions collect on them. These particulates are therefore repelled from electrode 26 by the dc component of the electric field at that electrode. The rf component of the electric field is too small to have any significant effect on repelling these particulates away from the wafer. However, the rf field induces an increase in the dc electric field which helps in repelling particulates from surfaces, including the wafer. By maintaining a plasma within the reactor at all times that wafers are in the chamber (including periods of wafer transfer) these particulates are kept away from the wafer.

For a plasma with zero rf component of the potential, the dc voltage $\overline{V}_p$ of the plasma is approximately equal to

$$kT_e \cdot \ln[\{m_i/2\pi m_e\}^{1/2}]/e$$

where $T_e$ is the temperature of the plasma electrons, $m_i$ is the mass of a typical plasma ion, $m_e$ is the mass of an electron and $e$ is the charge of an electron. For typical masses of plasma ions (i.e., about 40 atomic mass units), this implies that $\overline{V}_p$ is on the order of $5kT_e/e$. If there is in addition an rf component of the plasma potential that is produced by an rf powered electrode in the plasma then the dc value of its potential rises to roughly the sum of the dc value plus the rf amplitude. The level of rf power and gas pressure determine $T_e$.

RF power supply 25 is typically capacitively coupled to powered electrode 26 so that this electrode's dc potential can float relative to grounded wall 21. If the electrode has smaller exposed area than the walls, the electrode floats to a potential nearly as negative as the amplitude of its rf potential (see, for example, the reference by J. Coburn cited above). This reduces sputtering of chamber wall 21 by reducing the sheath potential at the boundary between the plasma body and the chamber wall.

The plasma could be maintained during periods of wafer transfer by continuing to pump rf energy from rf power supply 25 into the plasma through electrode 26. In such a case, the rf power would be reduced during such wafer transfer periods to the minimal level that substantially keeps particulates from settling onto the wafer. This would minimize any processing of the wafer during such transfer periods while preventing particulates from settling onto the wafer. This would, however, still cause the highest energy ions to hit the wafer, as well as the bare electrode.

Unfortunately, the insertion of the wafer handling robot 39 into chamber 22 will disrupt the electric fields near powered electrode 26 producing unwanted variable processing of the wafer or shutting off the plasma above the wafer where it is most needed. Also, movement of the wafer across the fields of powered electrode 26 will also introduce variable processing of the wafer. In order to produce submicron features, it is necessary to take elaborate steps to preserve, to the extent possible, complete process symmetry across the entire wafer. The removal of the wafer while electrode 26 is powered could destroy such uniformity during wafer transfer. It is therefore preferable to decouple power electrode 26 and produce plasma from an alternate source. It is also desirable to use nonreactant gases during transfer so as not to have processing take place during this transfer operation. In the embodiment of Figure 4, this alternate plasma source consists of auxiliary rf source 41 which couples rf power into auxiliary power electrode assembly 42. In an alternate embodiment, rf source 41 can be omitted and replaced by switchable power from rf power supply 25.

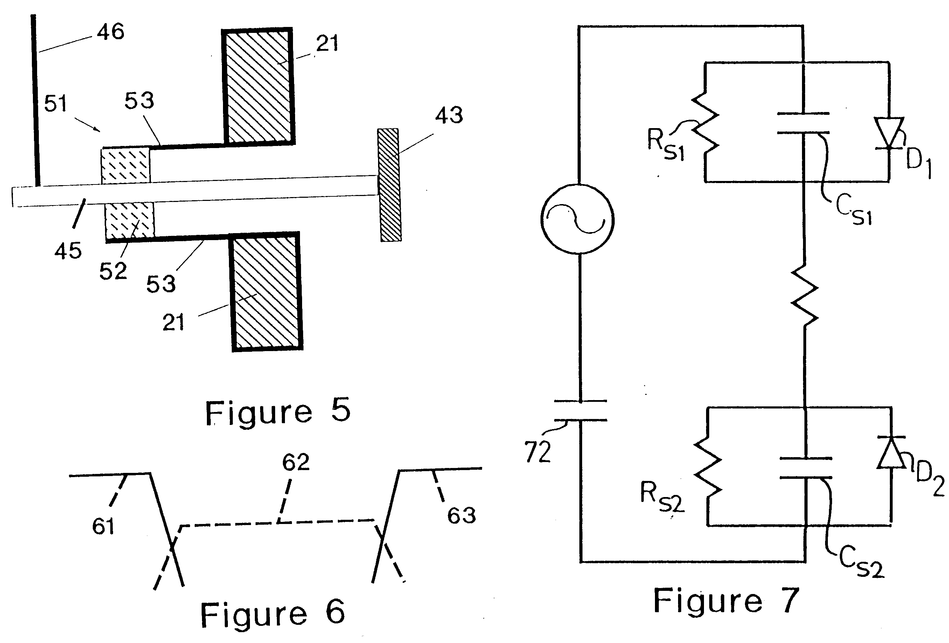

There are many known ways to couple power from an rf source to a powered electrode. A particularly simple embodiment of electrode 43 is presented in Figure 5. Hollow gas feed 45 enters chamber 22 through an insulating power feed 51 consisting of a ceramic end section 52 and a sidewall 53. This gas feed ejects gas into chamber 22 through holes in electrode 43. The diameter and length of electrode 43 are such that its surface area is less than that of the main electrode and therefore it produces a modest rf component of the plasma potential. This reduces sputtering of the walls and wafer during transfer.

Figure 7 shows the equivalent circuit of the electrical discharge in the plasma reactor. The positive electric charge in the sheath region between the plasma body and the electrode surfaces is capacitive charge storage that can be modeled as a capacitance $C_{s1}$ between the powered electrode and the plasma body. There is also a capacitance $C_{s2}$ between the walls and the plasma body. The plasma itself is essentially resistive for rf frequencies below the "plasma frequency". The low conductivity of the sheath introduces a high resistive component $R_{s1}$ in parallel with $C_{s1}$ and a high resistive component $R_{s2}$ in parallel with $C_{s2}$. The high conductivity of the plasma means that the plasma functions as a low resistive component $R_p$.

The difference in mobility of the electrons and the ions results in some rectification that is modeled via diodes $D_1$ and $D_2$. A blocking capacitor 72 between powered electrode 26 and the power supply enables the dc potential of powered electrode 26 to float. For dc and typical rf frequencies, the effects of diodes $D_1$ and $D_2$, and of resistances $R_{s1}$ and $R_{s2}$ can be ignored. The result is that capacitors C, $C_{s1}$ and $C_{s2}$ function as a capacitive divider. From such analysis, it has been determined that the auxiliary electrode should have a diameter on the order of five centimeters such that with a power input on the order of 100 Watts the resulting plasma, which has an electron density of order $10^9$ cm$^{-3}$, has an rf potential less than 40 volts.

Figure 6 is a timing diagram that plots as a function of time the power provided by rf sources 25 (shown as solid lines 61 and 63) and 41 (shown as dashed line 62). This diagram illustrates that power is provided at all times while a wafer is in the chamber. This assures that plasma is present in the chamber at all times. The wafer transfer occurs during the interval T when no power is supplied to the main processing electrode 26. It should be noted that the amount of power from rf power source 41 will have a peak value that is usually substantially less than the peak value of power from rf power source 25. The amount of power required from auxiliary rf source 41 is determined by the geometry of the plasma reactor and the maximum size of particulates that are to be electrostatically repelled away from the wafer.

The current and voltage of rf power supply 25 are typically selected to produce a plasma body charge density on the order of $10^9$ - $10^{11}$ free electrons per cubic centimeter. The pressure in the reactor chamber is typically on the order of 1.3 - $1.3 \cdot 10^3$ Pa ($10^{-2}$ - 10 Torr). With these choices of parameters, the dc plasma potential is typically on the order of 10-100 volts.

The effect of particulate size on minimum power 62 from the auxiliary plasma source can be seen as follows. Typically particulates have a density on the order of 3 grams per cubic centimeter so that a particulate of diameter on the order of 1 micron weighs on the order of $10^{-14}$ Newtons. If this particulate is charged, with 1000 electrons net charge, then the electric field at powered electrode 26 should exceed $10^{-14}$ Newtons/$1.6 \cdot 10^{-16}$ Coulombs which means a field of 0.60 volts/cm to repel the particulate against gravity. This requires a minimal plasma electron density on the order of $10^8$ to $10^9$ cm$^{-3}$ to cause this degree of charge-up of the particle and therefore requires a minimum auxiliary power on the order of 10-100 Watts, depending on the chamber volume. Typical chamber volumes range from 1 liter to as much as 10's of liters. The magnitude of the electric field at the sheath above the wafer is on the order of $5kT_e/e\lambda_D$ where $\lambda_D$ is the Debye length which is equal to $[\epsilon_0 kT_e/ne^2]^{1/2}$ and which is less than 1 mm at a density of $10^9$ free electrons per $cm^3$. This field is on the order of 10-100 volts/cm which easily satisfies the field requirements to keep particulates away from the wafer. Conversely, the dc sheath voltage above electrode 26 should be not much more than about 25 volts to avoid significant sputtering of the thin films on the surface of the wafer during the wafer exchange intervals. Therefore, the peak rf power supplied to electrode assembly 42 should be in the range from ten to a few hundred Watts. Since the particulate charge (and hence the electric force) increases linearly with particulate diameter and its weight increases as particulate diameter to the third power, this range of rf power will prevent particulates on the order of several microns or smaller from depositing onto the wafer.

As discussed above, when the particulates become negatively charged, the dc field between the electrodes and the plasma repels these negatively charged particulates away from the wafer. It was also indicated that this negative charge on the particulates arises because the electrons are so much more mobile than are the plasma ions. Implicitly, this assumes that the plasma contains a sufficient number of electrons that indeed the particulates become negatively charged. This will usually be the case, but there are some reactant gases that are sufficiently electronegative that this will not be the case at modest power levels. When such gases are used in processing, then, during the wafer exchange intervals, the processing gases should be purged from the plasma reactor chamber as quickly as possible and replaced with a nonhalogcnated feed gas such that the particulates become negatively charged during the wafer exchange intervals. After the wafer exchange interval, these wafer transfer reactants are purged from the chamber and replaced by suitable process reactants.

Typical process gases include $CHF_3$, $CF_4$, $SF_6$, HBr, HCl, $Cl_2$, $BCl_3$, $CF_2Cl_2$, $SiF_4$, $O_2$, Ar, and He. Of these, $O_2$, Ar, He and $CF_4$ have a sufficiently low electronegativity that particulates become strongly negatively charged in low power plasmas containing these reactants. Other useful choices are He, $N_2$ and $CO_2$. These examples are not exhaustive, but instead are illustrative of suitable reactant gases for the wafer exchange intervals.

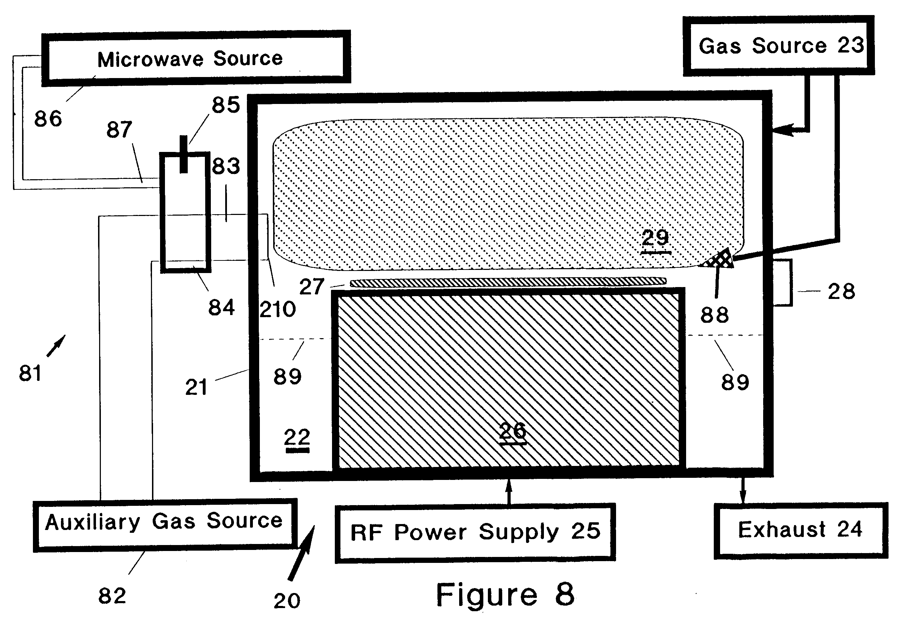

Figure 8 illustrates an alternate embodiment in which the auxiliary plasma source is a microwave plasma source 81. This microwave plasma source consists of a gas source 82 that supplies reactant gases into chamber 22 through a tube 83 such as a quartz tube. This tube passes through a microwave cavity 84 which is tuned by means of a tuning stub 85. Microwave power is provided from a microwave source 86 to cavity 84 through a coaxial cable 87. The amount of microwave power should be sufficient to produce a plasma such that the sheath at electrode 26 has an electric field sufficiently strong to repel the particulates. The power requirements are substantially the same as for an rf generated plasma.

In order to prevent particulates from depositing on a wafer, it is advantageous not only to repel the particulates vertically away from the surface of the wafer, but in addition to draw these particulates laterally away from the wafer. One such method consists of tilting the wafer away from being horizontal. For example, if the wafer is tilted by 15°, then the combination of a vertical gravitational force on the particulates and an electrical repulsion normal to the surface of the wafer will produce a lateral force that will carry the particulates laterally away from the wafer. Alternatively, a gas nozzle , such as nozzle 88 can be included to provide a lateral flow of gas across the wafer. Preferably, this flow is toward the exhaust 24 so that these particulates are removed from chamber 22. Above the exhaust manifold to exhaust system 24 are screens 89 that prevent the plasma from extending too far into the exhaust ports. However, the resulting electric field at these screens can be large enough to prevent these particulates from getting past these screens. To enable them to pass these screens, the hole in the screen should be sufficiently large that the resulting electric field at these holes is low enough that the weight of these particulates and the flow of air through the screen will draw these particulates past these screens. A hole size in the screen on the order of several to ten millimeters is sufficient to let most of these particulates pass through these screens.

## Claims

1. A method of repelling particulates from wafers (27) within a plasma reactor chamber (22) containing reactant gases, said method comprising the steps of:

(a) during wafer processing periods, causing there to be a plasma within the reactor; and

(b) during substantially all periods in which a wafer (27) is within the reactor chamber (22) and in which substantially no processing of the wafer (27) is to occur, causing there to be a lower power, substantially nonprocessing plasma within the reactor, whereby particulates in the reactor chamber (22) will acquire a net negative charge and thus can be repelled away from the wafer (27) at all times that the wafer (27) is within the reactor chamber (22).

2. A method as in claim 1 wherein, in step (b), the electron and ion charge densities and mobilities within the reactor chamber (22) are such that a dc electric field is generated in a plasma sheath just above the wafer (27) sufficient to repel negatively charged particulates away from the wafer (27), said dc electric field at the wafer (27) preferably being at least 1.0 Volts/cm.

3. A method as in claim 1 or 2, wherein step (b) comprises generating plasma from an auxiliary plasma source, preferably a microwave plasma generator (83-87) coupled to supply this plasma to the reactor chamber (22) or from an auxiliary rf powered electrode (43) in the reactor chamber (22).

4. A method as in any preceding claim wherein, during periods of wafer transfer, the reactivity and density of the plasma is less than during periods of wafer processing.

5. A method as in any preceding claim wherein, during periods of wafer transfer, wafers (27) are transferred between the reactor chamber (22) and the exterior of the reactor chamber (22) through a narrow wafer transfer valve (28), whereby the amount of plasma flowing out of the reactor chamber (22) during such transfer is minimized.

6. A method as in any preceding claim wherein, during at least part of step (b), the reactant gases within the reactor chamber (22) are replaced with reactant gases that are nonhalogenated and sufficiently electropositive that enough free electrons are generated in the plasma that particulates become negatively charged by the plasma during periods of wafer transfer.

7. A method as in any preceding claim wherein, in step (b), the wafer (27) is tilted to an angle away from horizontal so that gravity and electromagnetic repulsion of particulates produces a net force that causes the particulates to drift across and then off the wafer (27), above the sheath preferably followed by a removal thereof from the reactor chamber (22) preferably via suitable sized holes in a plasma confining screen.

8. A method as in any preceding claim wherein, in step (b), a flow of gas is directed across the wafer (27) during periods of wafer transfer to carry particulates laterally across and then away from the wafer (27) preferably followed by a removal from the reactor chamber (22) preferably via suitable sized holes in a plasma confining screen.

9. A plasma reactor (20;81) comprising:
a wall (21) enclosing a chamber (22);
first means (23,25,26) for generating a plasma suitable for processing a wafer (27) within said reactor chamber (22); and
second means (41-44;82-87) for generating a substantially nonprocessing plasma within said chamber (22), thereby enabling a nonprocessing plasma to be produced in said chamber (22) to repel particulates from a wafer within said chamber (22) during periods in which no processing of said wafer (27) is desired.

10. A reactor (20;81) as in claim 9, wherein said second means for generating a substantially nonprocessing plasma comprises an auxiliary electrode (43) connected to an electrical power source (41;25) or a microwave plasma source (83-87).

11. A reactor (81) as in claim 9 or 10, further comprising means for directing a flow of gas across said wafer (27), preferably in the form of a nozzle (88) connected to a gas source (23).

12. A reactor (81) as in any of claims 9 to 11, further comprising means (82) for replacing reactant gases during nonprocessing periods with an auxiliary gas capable of maintaining a low level plasma sufficient to repel particulates away from said wafer (27), with said auxiliary gas preferably being nonhalogenated and sufficiently electropositive that particulates within the reactor chamber (22) become negatively charged.

13. A reactor (81) as in any of claims 9 to 12, further comprising a set of screens (89) within an exhaust port to prevent the plasma from extending past the screens (89), said screens having openings of at least 4 mm diameter, whereby any electric field at such openings is sufficiently weak that particulates can drop through these openings.

**Patentansprüche**

1. Ein Verfahren zum Rückstoßen von Partikeln von Halbleiterscheiben (27) innerhalb einer Reaktionsgase enthaltenden Plasma-Reaktorkammer (22), wobei das Verfahren die Schritte aufweist:

(a) daß dort während Halbleiter-Bearbeitungszeiträumen ein Plasma im Reaktor erzeugt wird; und

(b) daß dort während im wesentlichen allen Zeiträumen, innerhalb derer sich eine Halbleiterscheibe (27) in der Reaktorkammer (22) befindet und innerhalb derer im wesentlichen keine Bearbeitung der Halbleiterscheibe (27) auftreten soll, ein im wesentlichen keine Bearbeitung bewirkendes Plasma mit einer niedrigeren Leistung innerhalb des Reaktors erzeugt wird, wodurch Partikel in der Reaktorkammer (22) eine negative Nettoladung bekommen und deshalb von der Halbleiterscheibe (27) zu jeder Zeit zurückgestoßen werden können, zu der sich die Halbleiterscheibe (27) in der Reaktorkammer (22) befindet.

2. Ein Verfahren nach Anspruch 1, wobei bei Schritt (b) die Ladungsdichten und Beweglichkeiten der Elektronen und Ionen in der Reaktorkammer (22) derart sind, daß ein elektrisches Gleichfeld, das zum Rückstoßen negativ geladener Partikel von der Halbleiterscheibe (27) weg ausreicht, in einer Plasmahülle genau über der Halbleiterscheibe (27) erzeugt wird, wobei das elektrische Gleichfeld bei der Halbleiterscheibe (27) vorzugsweise wenigstens 1,0 Volt/cm beträgt.

3. Ein Verfahren nach Anspruch 1 oder 2, wobei Schritt (b) das Erzeugen eines Plasmas von einer Hilfsplasmaquelle, vorzugsweise einem zum Zuführen dieses Plasmas zu der Reaktorkammer (22) angekoppelten Mikrowellen-Plasmagenerator (83 - 87), oder von einer Hilfselektrode (43) mit angelegter Hochfrequenzleistung in der Reaktorkammer (22) aufweist.

4. Ein Verfahren nach irgendeinem vorhergehenden Anspruch, wobei während der Zeiträume der Halbleiterscheiben-Umladung die Reaktionsfähigkeit und die Dichte des Plasmas geringer ist als während der Zeiträume der Halbleiterscheiben-Bearbeitung.

5. Ein Verfahren nach irgendeinem vorhergehenden Anspruch, wobei die Halbleiterscheiben (27) während der Zeiträume der Kalbleiterscheiben-Umladung zwischen der Reaktorkammer (22) und dem Außenraum der Reaktorkammer (22) über eine enge Halbleiterscheiben-Umladungsklappe (28) transportiert werden, wodurch der Anteil des aus der Reaktorkammer (22) während einer solchen Umladung ausfließenden Plasmas minimiert wird.

6. Ein Verfahren nach irgendeinem vorhergehenden Anspruch, wobei die Reaktionsgase innerhalb der Reaktorkammer (22) während zumindest eines Teils des Schritts (b) durch Reaktionsgase ersetzt werden, die nichthalogeniert und ausreichend elektropositiv sind, damit genügend freie Elektronen in dem Plasma erzeugt werden, so daß Partikel während der Zeiträume der Halbleiterscheiben-Umladung durch das Plasma negativ aufgeladen werden.

7. Ein Verfahren nach irgendeinem vorhergehenden Anspruch, wobei die Halbleiterscheibe (27) bei Schritt (b) um einen Winkel aus der Horizontalen weggeschwenkt wird, so daß Schwerkraft und elektromagnetische Abstoßung von Partikeln eine Nettokraft erzeugen, die oberhalb der Hülle ein Driften der Partikel über die Halbleiterscheibe (27) und dann ein Wegdriften von dieser bewirkt, wonach vorzugsweise ein Entfernen der Partikel aus der Reaktorkammer (22), vorzugsweise über geeignet bemessene Löcher in einem Plasma-Begrenzungs-Schirm folgt.

8. Ein Verfahren nach irgendeinem vorhergehenden Anspruch, wobei bei Schritt (b) während Zeiträumen der Halbleiterscheiben-Umladung ein Gasfluß über die Halbleiterscheibe (27) gerichtet ist, um Partikel seitlich über die Halbleiterscheibe (27) und dann von dieser weg zu tragen, wonach vorzugsweise ein Entfernen aus der Reaktorkammer (22), vorzugsweise über geeignet bemessene Löcher in einem Plasma-Begrenzungs-Schirm folgt.

9. Ein Plasmareaktor (20; 81), aufweisend:
eine Wandung (21), die eine Kammer (22) einschließt;
eine erste Einrichtung (23, 25, 26) zum Erzeugen eines Plasmas, das für eine Bearbeitung einer Halbleiterscheibe (27) in der Reaktorkammer (22) geeignet ist; und
eine zweite Einrichtung (41 - 44; 82 - 87) zum Erzeugen eines im wesentlichen keine Bearbeitung bewirkenden Plasmas innerhalb der Kammer (22), wodurch ein keine Bearbeitung bewirkendes Plasma in der Kammer (22) erzeugt werden kann, um Partikel von einer Halbleiterscheibe innerhalb der Kammer (22) während Zeiträumen zurückzustoßen, in denen keine Bearbeitung der Halbleiterscheibe (27) gewünscht ist.

10. Ein Reaktor (20; 81) nach Anspruch 9, wobei die zweite Einrichtung zum Erzeugen eines im wesentlichen keine Bearbeitung bewirkenden Plasmas eine Hilfselektrode (43), die mit einer elektrischen Leistungsquelle (41; 25) verbunden ist, oder eine Mikrowellen-Plasmaquelle (83 - 87) aufweist.

11. Ein Reaktor (81) nach Anspruch 9 oder 10, der ferner eine Einrichtung zum Richten eines Gasflusses über die Halbleiterscheibe (27), vorzugsweise in der Form einer mit einer Gasquelle (23) verbundenen Düse (88) aufweist.

12. Ein Reaktor (81) nach einem der Ansprüche 9 bis 11, der ferner eine Einrichtung (82) zum Ersetzen von Reaktionsgasen während Zeiträumen, in denen keine Bearbeitung erfolgt, durch ein Hilfsgas aufweist, das zum Aufrechterhalten eines Plasmas mit niedriger Stärke geeignet ist, das zum Zurückstoßen von Partikeln von der Halbleiterscheibe (27) ausreicht, wobei das Hilfsgas vorzugsweise nichthalogeniert und ausreichend elektropositiv ist, damit Partikel innerhalb der Reaktorkammer (22) negativ aufgeladen werden.

13. Ein Reaktor (81) nach einem der Ansprüche 9 bis 12, der ferner einen Satz von Schirmen (89) innerhalb einer Auslaßöffnung zum Verhindern, daß sich das Plasma über die Schirme (89) hinaus erstreckt, aufweist, wobei die Schirme Öffnungen von zumindest 4 mm Durchmesser aufweisen, wodurch jedes beliebige elektrische Feld an solchen Öffnungen ausreichend schwach ist, daß Partikel durch diese Öffnungen fallen können.

**Revendications**

1. Procédé pour repousser des particules de tranches (27) à l'intérieur d'une chambre de réacteur activé par plasma (22) contenant des gaz réactifs, ledit procédé comprenant les étapes consistant à :
   (a) pendant les périodes de traitement des tranches, faire en sorte d'avoir un plasma à l'intérieur du réacteur, et
   (b) pendant pratiquement toutes les périodes dans lesquelles une tranche (27) est à l'intérieur de la chambre de réacteur (22) et dans laquelle pratiquement aucun traitement n'est effectué sur la tranche (27), amener celle-ci à une puissance plus basse, sans pratiquement aucun traitement par plasma à l'intérieur du réacteur, d'où il résulte que les particules dans la chambre de réacteur (22) acquièrent une charge négative nette et ainsi peuvent être repoussées de la tranche (27) à tout moment, lorsque la tranche (27) est à l'intérieur de la chambre de réacteur (22).

2. Procédé selon la revendication 1, dans lequel, à l'étape (b), les densités de charge des électrons et des ions et les mobilités des électrons et des ions à l'intérieur de la chambre de réacteur (22) sont telles qu'un champ électrique à courant continu est produit dans un écran de plasma juste au-dessus de la tranche (27) suffisant pour repousser les particules chargées négativement loin de la tranche (27), ledit champ électrique à courant continu au niveau de la tranche (27) étant de préférence d'au moins 1 volt/cm.

3. Procédé selon la revendication 1 ou 2, dans lequel l'étape (b) comprend la production de plasma à partir d'une source de plasma auxiliaire, de préférence un générateur de plasma micro-onde (83 à 87) couplé pour alimenter ce plasma dans la chambre de réacteur (22) ou à partir d'une électrode alimentée hf auxiliaire (43) dans la chambre de réacteur (22).

4. Procédé selon l'une quelconque des revendications précédentes, dans lequel pendant les périodes de transfert de tranche, la réactivité et la densité de plasma sont inférieures à celles pendant les périodes de traitement de la tranche.

5. Procédé selon l'une quelconque des revendications précédentes, dans lequel pendant les périodes de transfert de tranche, les tranches (27) sont transférées entre la chambre de réacteur (22) et l'extérieur de la chambre de réacteur (22) par l'intermédiaire d'une fente de transfert de tranche étroite (28), d'où il résulte que le volume de plasma s'écoulant hors de la chambre de réacteur (22) durant un tel transfert est minimisé.

6. Procédé selon l'une quelconque des revendications précédentes, dans lequel pendant au moins une partie de l'étape (b), les gaz réactifs à l'intérieur de la chambre de réacteur (22) sont remplacés par des gaz réactifs qui sont non halogènes et suffisamment électropositifs pour que des électrons assez libres soient produits dans le plasma, de sorte que les particules deviennent négativement chargées par le plasma pendant les périodes de transfert de tranche.

7. Procédé selon l'une quelconque des revendications précédentes, dans lequel, à l'étape (b), la tranche (27) est inclinée à un angle éloigné de l'horizontale, de sorte que la répulsion par pesanteur et électromagnétique des particules produise une force nette qui amène les particules à glisser à travers et ensuite hors de la tranche (27), au-dessus de la protection de préférence suivi par l'enlèvement de celles-ci à partir de la chambre de réacteur (22), de préférence par l'intermédiaire de trous dimensionnés de manière appropriée dans un écran de confinement à plasma.

8. Procédé selon l'une quelconque des revendication précédentes, dans lequel, à l'étape (b), un flux de gaz est dirigé à travers la tranche (27) pendant les périodes de transfert de tranche pour transporter latéralement les particules et ensuite loin de la tranche (27) de préférence suivi par l'enlèvement à partir de la chambre de réacteur (22) effectué de préférence par l'intermédiaire de trous dimensionnés de manière appropriée dans un écran de confinement à plasma.

9. Réacteur à plasma (20, 81) comprenant :
   une paroi (21) entourant une chambre (22),
   un premier moyen (23, 25, 26) pour produire un plasma approprié pour le traitement d'une tranche (27) à l'intérieur de ladite chambre de réacteur (22), et
   un second moyen (41 à 44, 82 à 87) pour produire un plasma pratiquement non traitant à l'intérieur de ladite chambre (22), permettant de ce fait à un plasma sans traitement d'être produit dans ladite chambre (22) pour repousser les particules d'une tranche à l'intérieur de ladite chambre (22) pendant les périodes dans lesquelles aucun traitement sur la tranche (27) n'est désiré.

10. Réacteur (20 ; 81) selon la revendication 9, dans lequel ledit second moyen pour produire un plasma sensiblement non traitant comprend une électrode auxiliaire raccordée à une source d'alimentation électrique (41 ; 25) ou à une source de plasma hyperfréquence (83 à 87).

11. Réacteur (81) selon la revendication 9 ou 10, comprenant de plus un moyen pour diriger un flux de gaz à travers ladite tranche (27), de préférence sous la forme d'une buse (88) raccordée à une source de gaz (23).

12. Réacteur (81) selon l'une quelconque des revendications 9 à 11, comprenant de plus un moyen (82) pour remplacer les gaz réactifs pendant les périodes sans traitement par un gaz auxiliaire pouvant maintenir un niveau de plasma faible suffisant pour repousser les particules loin de ladite tranche (27), avec ledit gaz auxiliaire étant de préférence non halogène et suffisamment électropositif, pour que les particules à l'intérieur de la chambre de réacteur (22) deviennent négativement chargées.

13. Réacteur (81) selon l'une quelconque des revendications 9 à 12, comprenant de plus un ensemble d'écrans (89) à l'intérieur d'un orifice d'évacuation pour empêcher le plasma de se développer au-delà des écrans (89), lesdits écrans ayant des ouvertures d'au moins un diamètre de 4 mm, d'où il résulte que tout champ électrique quelconque à ces ouvertures est suffisamment faible pour que les particules puissent chuter à travers ces ouvertures.

EP 0 419 930 B1

Aerosols

Metallurgical Dust

Tobacco          Cement

Smoke            Dust

Insecticide

Dust

Human

Hair

Diameter

0.001   0.01   0.1   1   10   100   1,000   10,000

(microns)

Figure 1

a

Causing A Plasma Within A
Plasma Reactor During
Wafer Processing Periods

b

Causing A Plasma Within A
Plasma Reactor During
Substantially All Nonprocessing
Periods A Wafer Is Within
The Reactor

Figure 9

Figure 2

Figure 3

Gas Source 23

Exhaust 24

RF Power Supply 25

Auxiliary RF Source 41

Auxiliary Gas Source 44

28

27

29

26

22

43

42

21

46

45

20

Figure 4

Figure 7

Figure 5

Figure 6

Figure 8

EP 0 419 930 B1